# FASCICULE DE BREVET EUROPEEN

(11) **EP 4 345 820 B1**
(45) Date de publication et mention de la délivrance du brevet: **16.07.2025**
(21) Numéro de dépôt: 23192686.6
(22) Date de dépôt: 22.08.2023
(51) Int. Cl.: G11C 11/22

(54) **CIRCUIT DE LECTURE NON-DESTRUCTIVE DE MEMOIRES FERROELECTRIQUES**
SCHALTUNG ZUM ZERSTÖRUNGSFREIEN AUSLESEN FERROELEKTRISCHER SPEICHER
NON-DESTRUCTIVE READING CIRCUIT FOR FERROELECTRIC MEMORIES

(30) Priorité: 28.09.2022 FR 2209851
(43) Date de publication de la demande: 03.04.2024
(73) Titulaire: Commissariat à l'Energie Atomique et aux Energies Alternatives, 75015 Paris (FR)
(72) Inventeur: BILLOINT, Olivier, 38054 GRENOBLE Cedex 09 (FR); GRENOUILLET, Laurent, 38054 GRENOBLE Cedex 09 (FR)
(74) Mandataire: Atout PI Laplace

(56) Documents cités:
- US-A1- 2021 020 222

## Description

### Champ d'application

L'invention concerne généralement des circuits de stockage de données à base de cellules mémoire non-volatile ferroélectrique. Plus particulièrement, l'invention concerne un circuit de lecture non-destructive des mémoires ferroélectriques.

### Problème soulevé

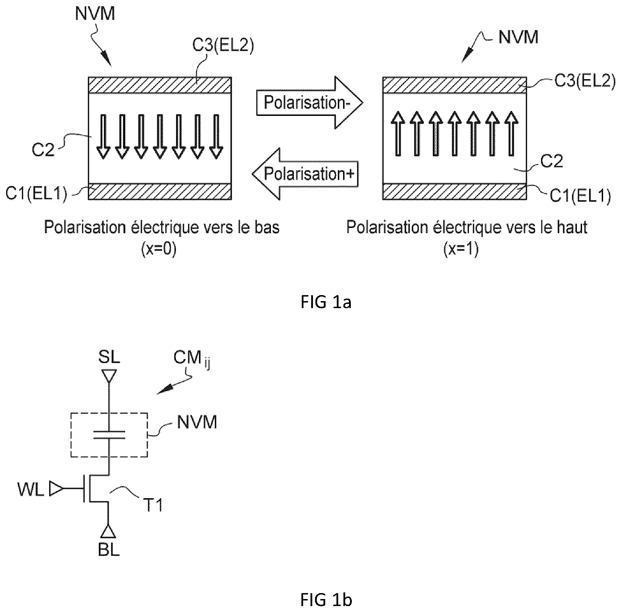

Les mémoires non volatiles présentent des solutions émergentes pour implémenter des moyens de stockage de données d'un circuit calculateur. Les mémoires ferroélectriques à polarisation électrique variable présentent une forte endurance en écriture et une basse énergie d'écriture. La figure 1a présente un exemple structurel d'un composant élémentaire NVM (Acronyme de l'expression anglaise Non Volatile Memory) d'une cellule mémoire ferroélectrique à polarisation électrique variable, plus précisément un composant de type FeRAM (acronyme de l'expresion anglaise Ferroelectric Random Access Memory).

Dans l'exemple illustré, le composant élémentaire NVM se compose de l'empilement de couches minces selon l'ordre suivant : une première couche C1 en un matériau électriquement conducteur formant une première électrode EL1 ; une deuxième couche C2 en un matériau diélectrique et ferroélectrique et une troisième couche C3 en matériau électriquement conducteur formant une seconde électrode EL2. On dénomme la deuxième couche C2 dans la suite de la description la « couche centrale ».

L'empilement de couches minces forme une structure de type MIM (acronyme Metal-Isolant-Metal) agissant comme un élément capacitif à une capacité C. Le caractère ferroélectrique de la couche centrale C2 induit le comportement suivant : lorsqu'une tension électrique positive est appliquée sur l'électrode supérieure EL2, la polarisation des dipôles électriques de la couche centrale est dirigée dans un sens dit « négatif ». Inversement, lorsqu'une tension électrique positive est appliquée sur l'électrode inférieure EL2, la polarisation des dipôles électriques est dirigée dans un sens dit « positif ». Le sens de la polarisation électrique dans la couche centrale C2 correspond à un état d'équilibre maintenu même en l'absence du champ électrique induit par la tension appliquée sur l'une des électrodes EL1 ou EL2, d'où le fonctionnement en mémoire ferroélectrique.

Ainsi, on choisit la convention suivante à titre d'exemple : lorsqu'un composant mémoire NVM est configuré pour stocker une donnée binaire à l'état logique bas (x= 0) on applique temporairement une tension électrique d'écriture sur l'électrode supérieure EL2 (illustré par polarisation +) de manière à obtenir une polarisation dirigée dans un sens « négatif »dans la couche centrale C2. Inversement, lorsqu'un composant mémoire NVM est configuré pour stocker une donnée binaire à l'état logique haut (x= 1) on applique temporairement une tension électrique d'écriture sur l'électrode inférieure EL1 (illustré par polarisation -) de manière à obtenir une polarisation dirigée dans un sens « positif » dans la couche centrale C2.

Cependant, l'opération de lecture d'une mémoire non-volatile ferroélectrique est une opération destructrice. En effet, lors d'un accès en lecture, le composant élémentaire NVM reçoit une tension électrique de lecture sur l'électrode supérieure de manière à la réécrire à un état logique bas (x=0). On observe ensuite la dynamique de la transition suite à l'application de la tension de lecture. Si les dipôles électriques de la couche centrale sont préalablement polarisés avec une orientation dans un sens « positif » (x=1), une quantité de charges électriques relativement importante sera émise par le dispositif pendant la transition. Inversement, si les dipôles électriques de la couche centrale sont préalablement polarisés avec une orientation dans un sens « négatif » (x=0), la quantité de charges délivrées pendant la transition est inférieure. Il en résulte que la procédure de lecture consiste à estimer la quantité de charges émises lors d'une polarisation à un état logique bas (x=0) et qu'elle efface donc la valeur logique de la donnée stockée.

Dans ce contexte, un problème technique à résoudre est la destruction du contenu logique d'une cellule mémoire ferroélectrique à polarisation électrique variable suite à une opération de lecture.

D'ailleurs, l'augmentation du nombre de cellules mémoires non-volatiles ferroélectriques induit une augmentation de la capacité parasite au niveau des lignes de bits BL (Bit line en Anglais). L'augmentation de la valeur de ladite capacité parasite induit une réduction drastique de la sensibilité des circuits de lecture connus.

De plus, la densification des matrices mémoires utilisées dans des systèmes embarqués nécessite une réduction de la surface occupée par chaque composant élémentaire NVM. Cela engendre une réduction de la capacité électrique de chaque composant élémentaire NVM. Cela induit une réduction de sensibilité de lecture de ce type de mémoires.

Pour résumer, plusieurs problèmes techniques se présentent concernant la lecture des mémoires ferroélectriques à polarisation électrique variable à savoir :

La destruction du contenu logique de la cellule mémoire suite à une lecture, et plus particulièrement pour un étage logique haut « x=1 ».

La diminution de la sensibilité de lecture avec l'élargissement des matrices de cellules mémoires et/ou la densification des matrices mémoires par réduction de la taille des composants élémentaires de stockage.

### Art antérieur/ Restrictions de l'état de l'art

La publication scientifique intitulée «1T1C FeRAM memory array based on ferroelectric HZO with capacitor under bitline" de J. Okuno et al présente un circuit de lecture d'une pluralité de mémoires de type FeRAM. La solution présentée est basée sur un pont capacitif diviseur connecté à la ligne de bits de la cellule mémoire à lire. La variation de tension à la sortie du pont diviseur capacitif par rapport à un signal de référence est amplifiée par un amplificateur de détection. L'amplitude de la dite variation dépend directement de la valeur de la capacité parasite au niveau de la ligne de bits ce qui engendre la perte de précision de lecture pour les raisons détaillés précédemment. De plus, dans la solution de Okuno, l'amplitude de la dite variation dépend directement de la valeur de la capacité du composant élémentaire ce qui réduit la sensibilité de lecture de pour les matrices densifiées. Un autre l'opération de lecture d'une cellule mémoire qui stocke un état logique haut.

Le publication de la demande de brevet américaine US 2021/020222 A1 décrit un autre circuit de stockage à base de mémoires de type FeRAM.

### Réponse au problème et apport solution

Pour répondre aux problèmes techniques discutés ci-dessus, liés à la lecture des mémoires non-volatile ferroélectriques, l'invention propose un circuit de lecture comprenant un étage amplificateur à transimpédance capacitive CTIA (acronyme du terme en anglais Capacitive Trans-Impedance Amplifier). Le circuit de lecture selon l'invention comprend ainsi une impédance de rétroaction capacitive permettant une lecture directe de la quantité de charges contenue dans le composant élémentaire de stockage ferroélectrique et non une lecture d'une variation de tension sur la ligne des bits. Cette solution permet ainsi de réaliser une opération de lecture dont la précision est indépendante des capacités parasites des lignes de bits. Cela permet ainsi de construire des matrices de taille plus grande sans être pénalisé par une diminution de la fenêtre mémoire.

De plus, la lecture dans le domaine des charges permet la limitation des variations du potentiel électrique au niveau des lignes de bits. Cela offre l'avantage d'une réduction considérable de la consommation électrique dynamique du circuit de stockage.

De plus, le circuit de lecture selon l'invention permet de réécrire la donnée lue (x=1) dans la cellule mémoire après chaque opération de lecture de manière à réaliser une opération de lecture non-destructive. L'opération de relecture est totalement intégrée par le circuit de lecture selon l'invention. Il n'y a pas besoin de recopier les données dans des mémoires tampons avant la lecture, ni de transférer lesdites données vers des circuits externes. Cela permet de réduire la complexité d'implémentation du circuit de stockage. Cela permet également de réduire la consommation énergétique du circuit de stockage par limitation des échanges de données en entrée et/ou sortie du circuit de stockage.

### Résumé /Revendications

L'invention a pour objet un circuit de stockage de données comprenant :
- une matrice de cellules mémoire telle que chaque cellule mémoire comprend :
   - un composant élémentaire de stockage de type ferroélectrique à polarisation électrique variable et ayant une première électrode et une seconde électrode ;
   - un premier nœud d'entrée/sortie connecté à la seconde électrode; un second nœud d'entrée/sortie; un nœud de sélection;
   - un transistor de sélection ayant une grille connectée au nœud de sélection et reliant la première électrode au second nœud d'entrée/sortie ;
      dans laquelle, chaque cellule mémoire peut présenter un premier ou un deuxième état logique correspondant respectivement à des niveaux différents de charges stockées dans le composant élémentaire de stockage associé ;
- un circuit de lecture associé à au moins une cellule mémoire, comprenant
   - un étage amplificateur à transimpédance capacitive configuré pour lire une donnée stockée dans une cellule mémoire sélectionnée via la mise en conduction du transistor de sélection correspondant en appliquant un signal de sélection sur le nœud de sélection ; ledit étage amplificateur à transimpédance capacitive comprenant :
      ∘ un amplificateur opérationnel ayant : une première entrée connectée au second nœud d'entrée/sortie de la cellule mémoire associée, une seconde entrée pour recevoir un premier signal de référence ; et une sortie pour fournir un signal de lecture analogique ;
      ∘ une impédance capacitive de rétroaction montée entre la sortie et la première entrée de l'amplificateur opérationnel.
         - un circuit séquenceur configuré pour, suite à la lecture d'une donnée correspondant au second état logique, appliquer un signal de contrôle sur le premier nœud d'entrée/sortie ayant une amplitude inférieure au premier signal de référence et maintenir le transistor de sélection à un état passant de sorte à remettre, dans le composant élémentaire de stockage de la cellule mémoire sélectionnée, un niveau de charges correspondant au second état logique.

Selon un aspect particulier de l'invention, ledit circuit séquenceur est configuré pour, lors de la lecture, appliquer un signal de contrôle sur le premier nœud d'entrée/sortie ayant une amplitude sensiblement égale au premier signal de référence de sorte à engendrer un transfert de charges depuis le composant élémentaire de stockage de la cellule sélectionnée vers ledit étage amplificateur à transimpédance capacitive.

Selon un aspect particulier de l'invention, ledit premier état logique correspond à un état non chargé d'un composant élémentaire de stockage. Le circuit séquenceur est tel que, suite à la lecture d'une donnée correspondant à un premier état logique , ledit circuit séquenceur est configuré pour rendre non conducteur ledit transistor de sélection de la cellule mémoire sélectionnée avant de modifier le signal de contrôle sur le premier nœud d'entrée/sortie vers une nouvelle valeur, pour maintenir la cellule mémoire venant d'être lue à un état non chargé.

Selon un aspect particulier de l'invention, le circuit de lecture comprend en outre un comparateur ayant
une première entrée connectée à la sortie de l'amplificateur opérationnel,
une seconde entrée pour recevoir un second signal de référence ;
et une sortie pour fournir un signal de lecture numérique.

Selon un aspect particulier de l'invention, le signal de contrôle est une première impulsion ; le signal de sélection est une seconde impulsion; le circuit séquenceur est configuré pour réduire la durée de la première impulsion par rapport à celle de la seconde impulsion suite à la lecture d'une donnée correspondant à un état logique haut.

Selon un aspect particulier de l'invention, le circuit de lecture comprend en outre un interrupteur de réinitialisation monté entre la sortie et la première entrée de l'amplificateur opérationnel.

Selon un aspect particulier de l'invention, le circuit de lecture comprend en outre un premier interrupteur d'activation de rétroaction entre l'impédance capacitive de rétroaction et la première entrée de l'amplificateur opérationnel.

Selon un aspect particulier de l'invention, le circuit de stockage de données comprend en outre un interrupteur d'activation de lecture entre la première entrée de l'amplificateur opérationnel et le second nœud d'entrée/sortie de la cellule mémoire associée.

Selon un aspect particulier de l'invention, le circuit de lecture est configuré pour réaliser en outre, avant la lecture de ladite cellule mémoire associée:
une étape de réinitialisation pour décharger l'impédance capacitive de rétroaction et polariser la première entrée de l'amplificateur opérationnel au premier signal de référence.

Selon un aspect particulier de l'invention, l'amplitude du premier signal de référence est comprise dans l'intervalle [VDD/2 - 50% ; VDD/2 + 50%] avec VDD une tension d'alimentation du circuit de stockage de données.

Selon un aspect particulier de l'invention, le circuit circuit de stockage comprend au moins un composant élémentaire de stockage configurable selon une configuration de fonctionnement correspondant à une mémoire résistive à filament conducteur variable ;
Le circuit de lecture comprenant en outre :
- une impédance résistive de rétroaction montée entre la sortie et la première entrée de l'amplificateur opérationnel;
- un second interrupteur d'activation de rétroaction entre l'impédance résistive de rétroaction et la première entrée de l'amplificateur opérationnel.

Selon un aspect particulier de l'invention, la matrice de cellules mémoire est composée de N lignes et M colonnes tel que :
- les cellules mémoire appartenant à une même colonne présentent des premiers nœuds d'entrée/sortie interconnectés, et des seconds nœuds d'entrée/sortie interconnectés ;
- les cellules mémoire appartenant à une même ligne présentent des nœuds de sélection interconnectés.

Selon un aspect particulier de l'invention, le composant élémentaire de stockage est de type FeRAM ou de type jonction tunnel ferroélectrique FTJ.

### Brève Description des Dessins

D'autres caractéristiques et avantages de la présente invention apparaîtront mieux à la lecture de la description qui suit en relation aux dessins annexés suivants.
[Fig. 1a] illustre une vue en coupe d'un exemple d'un composant élémentaire d'une cellule mémoire ferroélectrique à polarisation électrique variable compatible avec l'invention. Cette figure est déjà décrite.
[Fig. 1b] illustre une modélisation électrique d'une cellule mémoire ferroélectrique à polarisation électrique variable compatible avec l'invention.
[Fig. 2] illustre un schéma électrique d'un premier mode de réalisation du circuit de lecture selon l'invention connecté à une cellule mémoire ferroélectrique à polarisation électrique variable.
[Fig. 3a] illustre un schéma électrique de la configuration du circuit de lecture selon l'invention lors d'une étape d'initialisation.
[Fig. 3b] illustre un schéma électrique de la configuration du circuit de lecture selon l'invention lors d'une étape de lecture.
[Fig. 3c] illustre un organigramme des signaux de contrôle de la cellule mémoire lors d'une étape de lecture par le circuit de lecture selon l'invention.
[Fig. 4] illustre un organigramme des signaux de contrôle de la cellule mémoire suite à la lecture d'un état logique bas (x=0) par le circuit de lecture selon l'invention.
[Fig. 5a] illustre un organigramme des signaux de contrôle de la cellule mémoire suite à la lecture d'un état logique haut (x=1) par le circuit de lecture selon l'invention.
[Fig. 5b] illustre un schéma électrique d'une première configuration du circuit de lecture selon l'invention lors d'une étape réécriture.
[Fig. 5c] illustre un schéma électrique d'une première configuration du circuit de lecture selon l'invention lors d'une étape réécriture.
[Fig. 5d] illustre un schéma électrique d'une première configuration du circuit de lecture selon l'invention lors d'une étape réécriture.
[Fig. 6a] illustre un schéma fonctionnel de l'architecture un premier mode de réalisation du circuit de stockage de données selon l'invention.
[Fig. 6b] illustre un schéma fonctionnel de l'architecture un second mode de réalisation du circuit de stockage de données selon l'invention.
[Fig. 7a] illustre une vue en coupe d'un exemple d'un composant élémentaire d'une cellule mémoire résistive à filament conducteur variable compatible avec l'invention.
[Fig. 7b] illustre un schéma électrique d'un second mode de réalisation du circuit de lecture selon l'invention connecté à une cellule mémoire résistive à filament conducteur variable.
[Fig. 7c] illustre un organigramme des signaux de contrôle de la cellule mémoire résistive lors de la lecture d'une cellule mémoire par le circuit de lecture selon l'invention.

La figure 1a, déjà décrite, illustre un composant élémentaire NVM de type FeRAM compatible avec l'invention. Nous soulignons qu'il est possible également de réaliser l'invention avec des composants élémentaires de type jonction à tunnel ferroélectrique FTJ (acronyme du terme anglais Ferroelectric Tunnel Junction) et tout autre type de technologie de mémoire non-volatile ferroélectrique à polarisation électrique variable.

La figure 1b illustre une modélisation électrique d'une cellule mémoire CMᵢⱼ ferroélectrique à polarisation électrique variable compatible avec l'invention. La cellule mémoire comprend CMᵢⱼ un composant élémentaire mémoire NVM, un transistor de sélection T1, un premier nœud d'entrée/sortie SL, un second nœud d'entrée/sortie BL et un nœud de sélection WL. La cellule mémoire CMᵢⱼ est destinée à être intégrée dans une matrice comprenant une pluralité de lignes de bits (bit line en anglais), une pluralité de lignes de mot (word line en anglais) et une pluralité de lignes de source (source line en anglais). Le premier nœud d'entrée/sortie SL est destiné à être connecté à une ligne de source associée à la cellule mémoire CMᵢⱼ. Le second nœud d'entrée/sortie BL est destiné à être connecté à une ligne de bits associée à la cellule mémoire CMᵢⱼ. Le nœud de sélection WL est destiné à être connecté à une ligne de mots associée à la cellule mémoire CMᵢⱼ

Au sein d'une cellule mémoire CMᵢⱼ, le premier nœud d'entrée/sortie (SL) est connecté à la seconde électrode EL2 du composant élémentaire mémoire NVM. Le transistor de sélection T1 a une grille connectée au nœud de sélection WL. Le transistor de sélection T1 relie la première électrode EL1 du composant élémentaire mémoire NVM au second nœud d'entrée/sortie BL. Le composant élémentaire NVM se comporte comme un élément capacitif présentant une capacité variable selon la direction de la polarisation électrique de la couche ferroélectrique centrale C2. On modélise ainsi la cellule mémoire CMᵢⱼ par une architecture compacte 1C1T. Cela permet une action directe sur les électrodes EL1 et EL2 de l'élément capacitif lorsque le transistor T1 est à l'état passant.

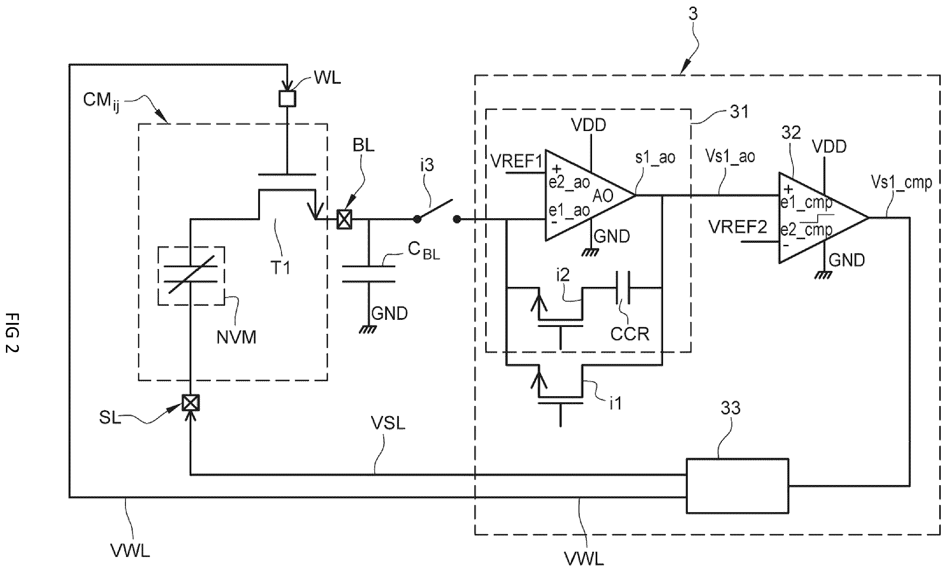

La figure 2 illustre un schéma électrique d'un premier mode de réalisation du circuit de lecture 3 selon l'invention connecté à une cellule mémoire CMᵢⱼ ferroélectrique à polarisation électrique variable.

Le circuit de lecture 3 est connecté au second nœud d'entrée/sortie BL de la cellule mémoire à lire CMᵢⱼ à travers un interrupteur d'activation de lecture i3. L'interrupteur d'activation de lecture i3 permet d'isoler le nœud BL du circuit de lecture 3 en cas de besoin. A titre d'exemple illustratif non-limitatif, la cellule mémoire CMᵢⱼ présente la même architecture décrite précédemment. La capacité parasite C_{BL} vue par le second nœud d'entrée/sortie BL est représentée ici afin de faciliter la compréhension de l'invention.

Le circuit de lecture 3 comprend un étage amplificateur à transimpédance capacitive 31 (traduction du terme en anglais Capacitive Trans-Impedance Amplifier) ; un comparateur 32, un circuit séquenceur 33 et un interrupteur de réinitialisation i1.

L'étage amplificateur à transimpédance capacitive 31 comprend un amplificateur opérationnel AO associé à une impédance capacitive de rétroaction (CCR). L'amplificateur opérationnel AO présente une première entrée e1_ao connectée au second nœud d'entrée/sortie BL de la cellule mémoire associée ; une seconde entrée e2_ao pour recevoir un premier signal de référence VREF1 ; et une sortie s1_ao pour fournir un signal de lecture Vs1_ao analogique. L'impédance capacitive de rétroaction CCR est montée entre la sortie s1_ao et la première entrée e1_ao de l'amplificateur opérationnel. Ce type de montage permet de réaliser une lecture directe de la quantité de charges contenue dans le composant élémentaire NVM et non une lecture d'une variation de tension sur le noeud BL. Ce montage permet ainsi de réaliser une opération de lecture dont la précision est indépendante de la capacité parasite C_{BL}.

L'amplificateur opérationnel AO présente une double fonction :
- maintenir le nœud BL à un potentiel fixe égal au potentiel du premier signal de référence VREF1 lorsque l'interrupteur d'activation de lecture i3 est passant.
- générer un signal de lecture Vs1_ao analogique ayant une l'amplitude dépendante de la quantité de charge transmise du composant élémentaire NVM vers l'impédance capacitive de rétroaction CCR lors d'une opération de lecture.

L'impédance capacitive de rétroaction CCR a pour fonction la conversion de la quantité de charges fournie par le composant élémentaire NVM (assimilable à un élément capacitif) en une tension électrique appliquée entre la sortie s1_ao et l'entrée e1_ao lors d'une opération de lecture.

Optionnellement, le circuit de lecture comprend un premier interrupteur d'activation de rétroaction i2 entre l'impédance capacitive de rétroaction CCR et la première entrée e1_ao de l'amplificateur opérationnel.

Le comparateur 32 présente une première entrée e1_cmp connecté à la sortie s1_ao de l'amplificateur opérationnel ; une seconde entrée e2_cmp pour recevoir un second signal de référence VREF2 ; et une sortie s1_cmp pour fournir un signal de lecture Vs1_cmp numérique résultant de la comparaison du signal de lecture Vs1_ao analogique avec le second signal de référence VREF2.

Le comparateur 32 et l'amplificateur opérationnel AO sont polarisés chacun par une tension d'alimentation VDD et la masse électrique GND.

Le circuit séquenceur 33 est configuré pour commander l'application :
- d'un signal de contrôle d'écriture et de lecture VSL sur le premier nœud d'entrée/sortie SL de la cellule mémoire associée;
- et d'un signal de sélection VWL sur le nœud de sélection WL de la cellule mémoire associée,

Il s'agit d'un circuit configuré selon une machine d'états afin d'adapter les caractéristiques des signaux VSL et WL selon le signal de lecture Vs1_cmp numérique. L'action du séquenceur 33 sur les signaux VSL et WL sera détaillée dans une section ultérieure. A titre d'exemple non limitatif, il est envisageable d'implémenter le circuit séquenceur 33 à l'aide d'un microcontrôleur intégré dans le circuit mémoire. Avantageusement, le séquenceur 33 permet de mettre en place une boucle de rétroaction permettant de réaliser une opération de réécriture par le circuit de lecture lui-même. Cela permet de s'affranchir des problèmes de lecture destructive sans complexifier le circuit. De plus, l'action du séquenceur permet de réaliser la réécriture sans transférer les données à des mémoires tampons externes.

L'interrupteur de réinitialisation i1 est monté entre la sortie s1_ao et la première entrée e1_ao de l'amplificateur opérationnel. Lorsque interrupteur de réinitialisation i1 est à l'état passant, l'impédance capacitive de rétroaction CCR est déchargée. Cette décharge induit également la réinitialisation du signal de lecture analogique Vs1_ao à un potentiel égal à celui du premier signal de référence VREF1.

Avantageusement, la fermeture de l'interrupteur de réinitialisation i1 permet de dissiper les charges cumulées sur le second nœud d'entrée/sortie BL à cause des courants de fuite. En effet, pour les nœuds technologiques avancés, ily a augmentation des courants de fuite provenant des transistors de sélection connectés au second nœud d'entrée/sortie BL. Ces courants de fuite entrainent une accumulation de charges au niveau de la capacité parasite C_{BL}. Cela induit des fluctuations de potentiel au niveau du second nœud d'entrée/sortie BL. D'où l'intérêt spécifique de l'interrupteur de réinitialisation i1 dans ce cas de figure.

L'ensemble des interrupteurs i1, i2 et i3 sont commandés par des moyens de contrôle non représentés pour simplifier l'illustration. Les interrupteurs i1, i2 et i3 sont réalisés par des transistors CMOS à titre d'exemple. Le circuit de lecture 3 est configuré pour réaliser les étapes suivantes :

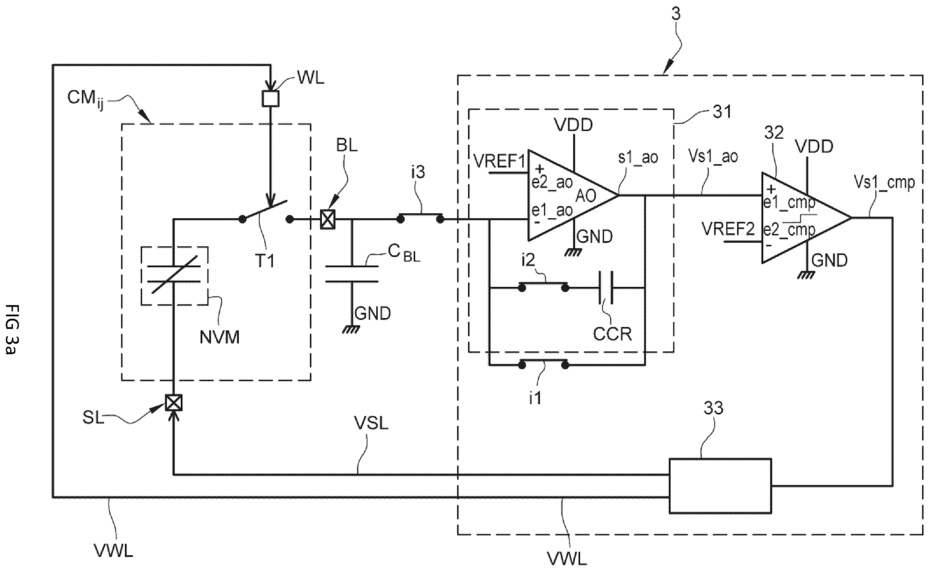

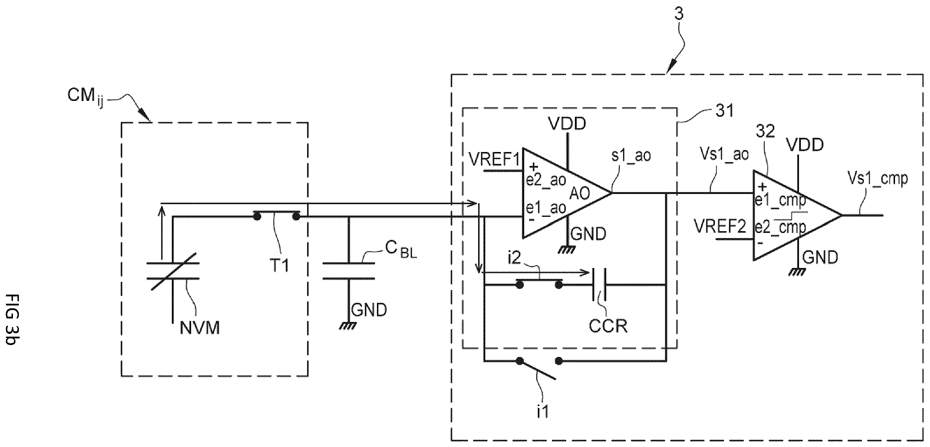

La première étape (i) est une étape de réinitialisation obtenue par la configuration illustrée par la figure 3a. L'interrupteur de réinitialisation i1, l'interrupteur d'activation de rétroaction i2 et l'interrupteur d'activation de lecture i3 sont fermés. Le séquenceur 33 génère un signal de sélection VWL de manière à mettre le transistor de sélection T1 à un état bloquant. Le séquenceur 33 génère un signal de contrôle d'écriture et de lecture VSL sur le premier nœud d'entrée/sortie SL égal à la masse électrique.
Cette étape (i) permet de décharger l'impédance capacitive de rétroaction CCR et de polariser la première entrée e1_ao de l'amplificateur opérationnel au premier signal de référence VREF1. Ainsi suite à la réinitialisation, le nœud d'entrée/sortie BL et la sortie s1_ao sont polarisés au premier signal de référence VREF1 (VBL= Vs1_ao= VREF1) ; la tension au bornes de l'impédance capacitive de rétroaction CCR est nulle ; et la sortie du comparateur s1_cmp est à un état logique bas (Vs1_cmp=0).

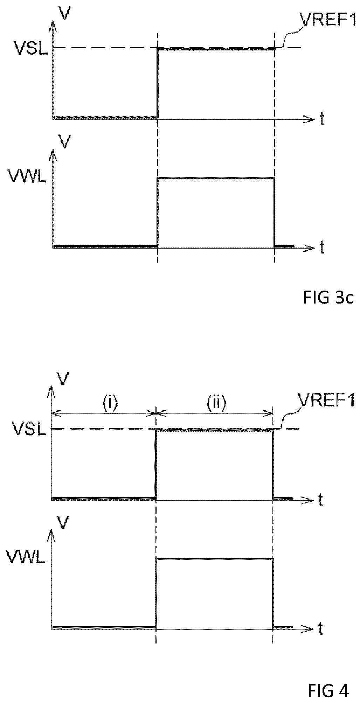

La deuxième étape (ii) est une étape de lecture obtenue par la configuration illustrée par la figure 3c. La Figure 3c illustre un organigramme des signaux VSL et VWL fournis par le séquenceur 33 lors d'une étape de lecture ii). L'interrupteur de réinitialisation i1 est ouvert et les interrupteurs i2 et i3 sont fermés (état passant).

Le séquenceur 33 est configuré au cours de cette étape pour appliquer un signal de sélection VWL permettant de mettre le transistor de sélection T1 à l'état passant (un front montant dans le cas d'un NMOS est illustré ici). Il en résulte la création d'un chemin de connexion entre le composant élémentaire NVM et l'élément capacitif de rétroaction CCR.

De plus, le séquenceur 33 est configuré pour appliquer un signal de contrôle de lecture VSL positif sur le premier nœud d'entrée/sortie SL. Il en résulte l'application d'une différence de potentiel quasi nulle aux bornes du composant élémentaire NVM.

Ainsi, la combinaison de la tension quasi nulle aux bornes du composant élémentaire NVM et sa connexion avec l'élément capacitif de rétroaction CCR, induit un transfert des charges préalablement stockés dans le composant élémentaire NVM vers l'élément capacitif de rétroaction CCR. La quantité de charge transférée dépend de l'état logique préalablement stocké dans la mémoire CMᵢⱼ. Cela induit une variation de la tension électrique VCCR aux bornes de l'élément capacitif de rétroaction CCR. La valeur de la tension électrique aux bornes de l'élément capacitif de rétroaction CCR dépend de la quantité de charges fournie par composant élémentaire NVM à l'élément capacitif de rétroaction CCR. Cela induit une variation du signal de sortie analogique Vs1_ao qui passe à VREF1-VCCR.

Dans le cas où x=1 est stockée dans le composant élémentaire NVM, on obtient Vs1_ao= VREF1-VCCR < VREF2 avec VCCR de l'ordre de quelques centaines de millivolts. On obtient ainsi Vs1_cmp=VDD correspondant à un niveau logique haut. Inversement, le cas où x=0 est stockée dans le composant élémentaire NVM, on obtient Vs1_ao= VREF1-VCCR > VREF2 et donc Vs1_cmp=GND correspondant à un niveau logique bas.

Nous soulignons que les charges sont transférées totalement vers l'élément capacitif de rétroaction CCR lors de cette étape. La capacité parasite C_{BL} ne reçoit pas ces charges car elle est maintenue à une tension égale à VREF1 grâce à l'amplificateur opérationnel AO durant toute l'opération. Le circuit de lecture 3 selon l'invention permet ainsi de réaliser une opération de lecture dans le domaine des charges indépendante de la valeur de la capacité parasite C_{BL}.

La troisième étape (iii) consiste en la réécriture de la donnée logique préalablement lue par le circuit de lecture 3. Nous rappelons que l'opération de réécriture n'est requise que dans le cas où la donnée lue correspond à un état logique haut. La figure 4 illustre un organigramme des signaux de contrôle de la cellule mémoire CMᵢⱼ suite à la lecture d'un état logique bas (x=0) par le circuit de lecture 3. Dans ce cas, le séquenceur 33 reçoit le signal de lecture numérique Vs1_cmp=0. En réponse à ce résultat, le séquenceur 33 est configuré pour émettre un front descendant simultanément sur les nœuds SL et WL. Cela permet d'isoler le composant élémentaire NVM du nœud BL et de maintenir l'état logique dudit composant élémentaire à x=0 obtenu suite à l'opération de lecture. (par pompage des charges lors de la lecture).

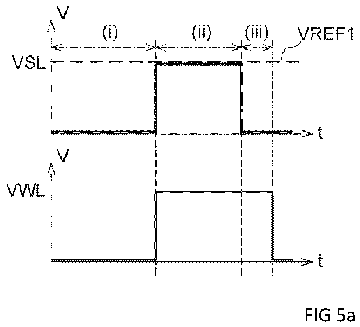

Alternativement, la figure 5a illustre un organigramme des signaux de contrôle de la cellule mémoire CMᵢⱼ suite à la lecture d'un état logique haut (x=1) par le circuit de lecture 3. Dans ce cas, le séquenceur 33 reçoit le signal de lecture numérique Vs1_cmp=VDD. En réponse à ce résultat, le séquenceur 33 est configuré pour appliquer un front descendant sur le nœud d'entrée/sortie SL tout en maintenant le nœud de sélection WL à un état haut. Il en résulte, la combinaison suivante :
- D'une part, le premier nœud d'entrée sortie SL est à un potentiel bas (de préférence nul) sous l'action du séquenceur 33 ;
- D'autre part, le second nœud d'entrée/sortie BL est à un potentiel électrique haut égal à VREF1 sous l'action de l'amplificateur opérationnel AO ; le transistor T1 étant à l'état passant ;

Cela correspond à l'application d'une tension d'écriture SET sur le composant élémentaire NVM comme expliqué dans la figure 1a. Ainsi, une opération de réécriture de la valeur logique x=1 a été effectuée via l'action du séquenceur 33 permettant de réaliser une opération de réécriture par le circuit de lecture lui-même. Cela permet de s'affranchir des problèmes de lecture destructive sans complexifier le circuit.

Nous allons dans ce qui suit décrire à titre illustratif non limitatif plusieurs configurations possibles du circuit de lecture lors d'une étape de réécriture suite à la lecture d'une donnée logique x=1.

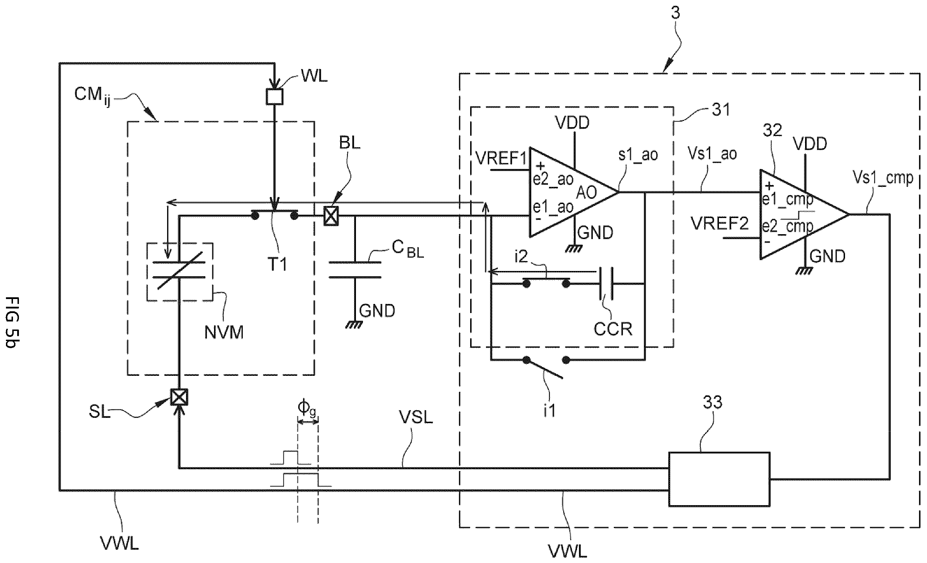

La figure 5b illustre un schéma électrique d'une première configuration du circuit de lecture 3 selon l'invention lors d'une étape de réécriture. Pour cette configuration, l'interrupteur d'activation de rétroaction i2 est maintenu fermé lors de l'étape de l'écriture de manière à rapatrier les charges cumulées dans la capacité de rétroaction CCR vers le composant élémentaire NVM. Les charges n'ont pas été évacuées en aval de l'amplificateur à transimpédance capacitive 31. Les charges transmises lors de la lecture sont rapatriées dans la cellule mémoire pour une réécriture de l'information avec une consommation énergétique moindre que dans la solution de l'état de l'art.

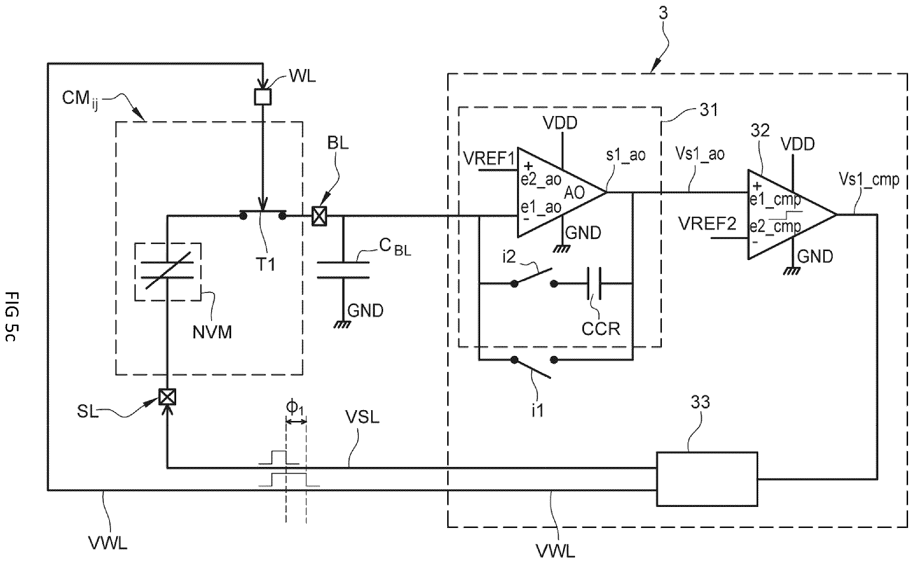

La figure 5c illustre un schéma électrique d'une deuxième configuration du circuit de lecture selon l'invention lors d'une étape de réécriture. Dans cette deuxième configuration, l'interrupteur d'activation de rétroaction i2 est ouvert. Cela permet de réécrire la cellule mémoire à l'aide de la différence de potentiel appliquée entre les nœuds SL et BL tout en gardant une copie de l'information lue dans l'impédance capacitive de rétroaction CCR.

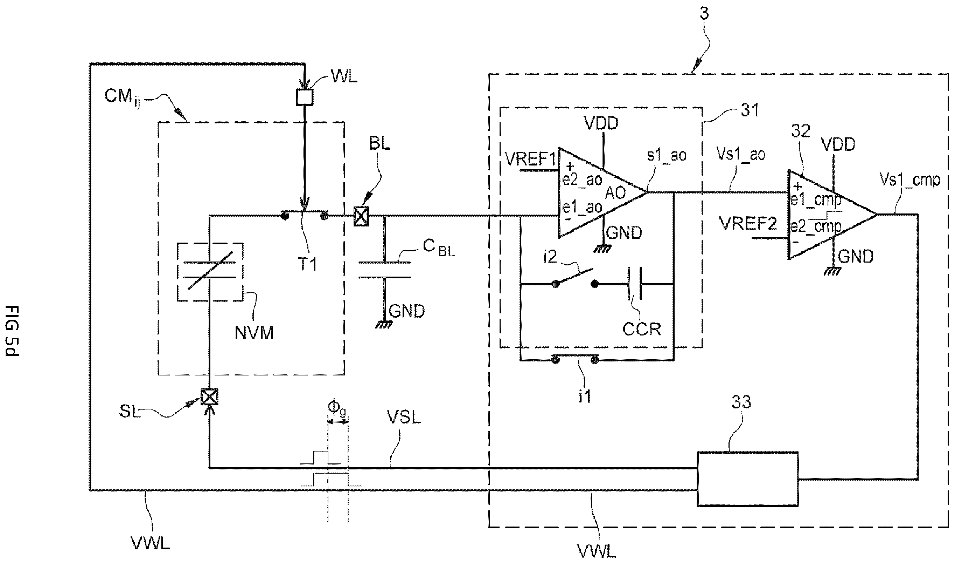

La figure 5d illustre un schéma électrique d'une troisième configuration du circuit de lecture selon l'invention lors d'une étape de réécriture. Dans cette deuxième configuration, l'interrupteur d'activation de rétroaction i2 est ouvert et l'interrupteur de réinitialisation i1 est fermé. Cela permet de réécrire la cellule mémoire à l'aide de la différence de potentiel appliquée entre les nœuds SL et BL. Cette configuration présente un avantage particulier dans le cas où la ligne de bits connectée au noeud BL est capacitive de manière à présenter un potentiel non égal à la tension de VREF1. La fermeture de l'interrupteur de réinitialisation i1 permet de repolariser correctement le noeud BL à la première tension de référence VREF1 via l'amplificateur à transimpédance capacitive 31. Cela permet de réécrire un état logique haut (x=1) d'une manière plus efficace.

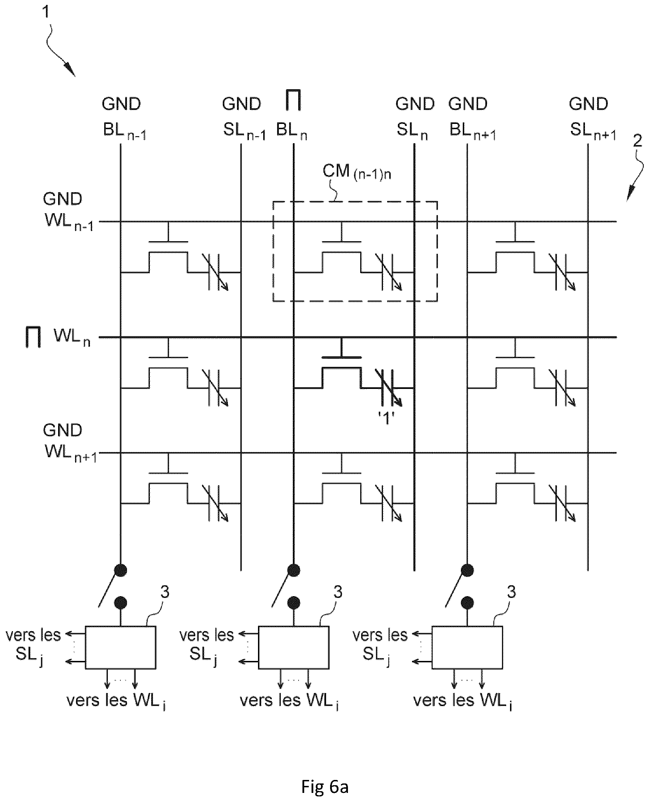

La figure 6a illustre un premier mode de réalisation du circuit de stockage 1 selon l'invention. Le circuit de stockage 1 selon l'invention comprend une matrice de cellules mémoire 2 et une pluralité de circuits de lecture 3. La matrice de cellules mémoires comprend N lignes et M colonnes. Les cellules mémoire CMᵢⱼ appartenant à une même colonne Cⱼ présentent des premiers nœuds d'entrée/sortie SL interconnectés via une ligne de source commune (SLₙ pour la colonne Cₙ). De plus, les cellules mémoire CMᵢⱼ appartenant à une même colonne Cⱼ présentent des seconds nœuds d'entrée/sortie BL interconnectés via une ligne de bits commune (BLₙ pour la colonne Cₙ). De plus, les cellules mémoire CMᵢⱼ appartenant à une même ligne Lᵢ présentent des nœuds de sélection WL interconnectés via une ligne de mots commune (WLₙ pour la colonne Lₙ). Il s'agit alors d'une structure de matrice avec les lignes de bits BLⱼ et les lignes de sources SLⱼ parallèles selon une première direction. Les lignes de mots WLᵢ sont orthogonales à ladite première direction. Le circuit de stockage 1 comprend au pied de chaque colonne Cⱼ un circuit de lecture 3 selon l'invention connecté à la ligne de bits BLⱼ de ladite colonne. Chaque circuit de lecture 3 agit via sa boucle de rétroaction sur les cellules mémoires CMᵢⱼ appartenant à la même colonne Cⱼ pour réaliser une lecture non-destructive. Cette configuration permet de réaliser une écriture et une lecture d'une cellule mémoire cible CMᵢⱼ sans perturber les cellules mémoires adjacentes en ligne ou en colonne. Pour cela il suffit de polariser les lignes de bits BLⱼ des cellules mémoires adjacentes à la masse électrique GND. De plus, cette configuration permet de réaliser des écritures/lectures en parallèle de l'ensemble des cellules mémoires appartenant à la même ligne Lᵢ. Cette parallélisation est possible grâce à l'indépendance entre les lignes de bits BLⱼ et les lignes de sources SLⱼ de cet ensemble des cellules mémoire.

Le circuit de stockage 1 comprend en outre des moyens d'écriture non représentés par souci de simplification. Les moyens d'écriture sont distincts du circuit de lecture selon l'invention. Les moyens d'écriture sont configurés pour réaliser des opérations d'écriture des données et n'interviennent pas dans les opérations de réécriture en réponse à une lecture destructive préalablement illustrées dans le cadre de l'invention

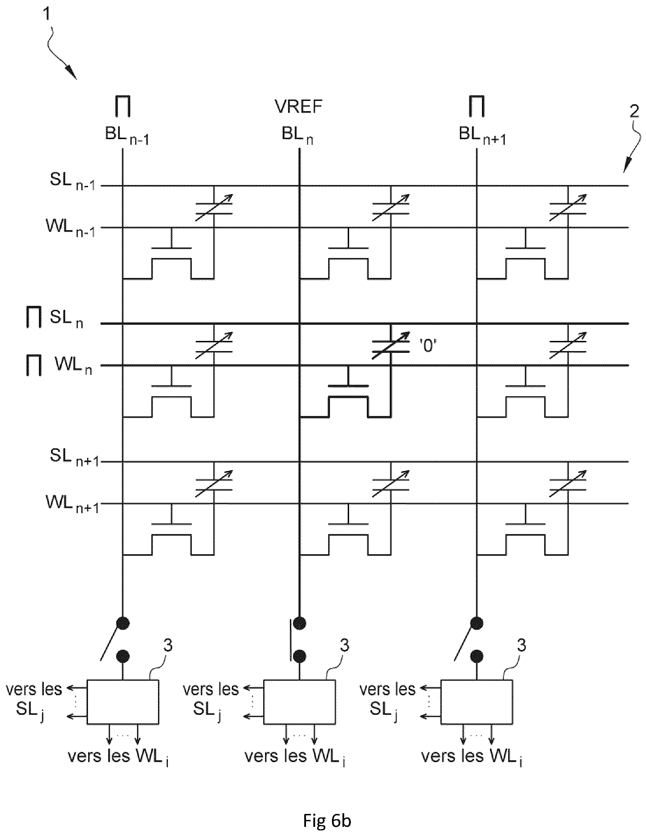

La figure 6b illustre un second mode de réalisation du circuit de stockage 1 selon l'invention. Le second mode de réalisation diffère du premier par l'orientation différente des lignes de sources SLₙ, SLₙ₋₁, SLₙ₊₁. En effet, dans ce mode de réalisation les lignes de source sont communes aux cellules mémoire CMᵢⱼ appartenant à la même ligne Lᵢ. Ainsi, les lignes de sources SLᵢ s'étendent selon une direction orthogonale à celle des lignes de bits BLⱼ et parallèle à celle des lignes de mots WLᵢ. Cette configuration est compatible avec l'invention à condition d'appliquer des signaux d'inhibition sur les lignes de bits BLⱼ des autres colonnes Cⱼ différentes de celle de la cellule mémoire sélectionnée pour une opération de lecture. Cela permet d'éviter les perturbations de l'état des cellules mémoires CMᵢⱼ appartenant à la même ligne de la cellule mémoire cible lors de sa lecture.

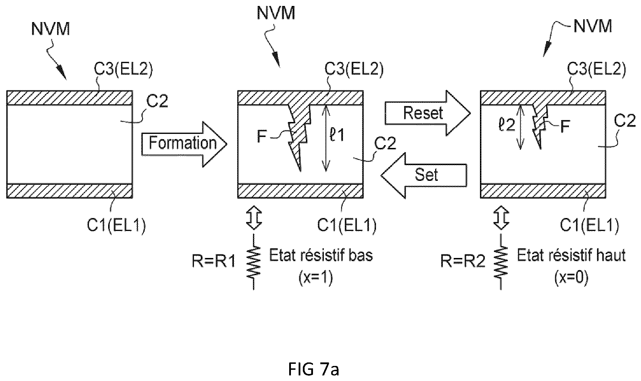

Dans la section suivante nous allons décrire un mode de réalisation de l'invention lorsque le circuit de stockage de données 1 comprend des cellules mémoires de type mémoire résistive à filament conducteur variable (OxRAM par exemple). Les cellules mémoires résistive à filament conducteur variable peuvent être co-intégrées avec les cellules mémoire ferroélectriques dans la même matrice 2. Alternativement, les cellules mémoires résistive à filament conducteur variable peuvent être intégrées dans une seconde matrice distincte de la matrice 2. Alternativement, il est possible de reconfigurer les cellules mémoire ferroélectrique selon un fonctionnement de type résistif à filament conducteur variable comme décrit dans la figure 7a.

La figure 7a illustre un composant élémentaire NVM d'une cellule mémoire résistive à filament conducteur variable compatible avec l'invention. Le fonctionnement résistif à filament conducteur variable nécessite la formation d'un filament conducteur F à travers au moins une partie de la couche centrale C2, isolante électriquement.

Initialement, le composant élémentaire NVM est une structure de type MIM (métal, isolant, métal) présentant une résistance infinie entre les deux électrodes EL1 et EL2. Afin de reconfigurer le composant élémentaire NVM selon un fonctionnement en mémoire résistive, il faut former le filament F partant de l'électrode supérieure EL2 à travers au moins une partie du volume de la couche centrale C2. La formation du filament permet d'obtenir une résistance variable en modulant la longueur I du filament conducteur formé. Pour former le filament, on applique une tension électrique de formation sur l'électrode supérieure EL2. La tension électrique de formation présente une amplitude et/ou une durée suffisamment élevée afin d'entrainer la génération de lacunes d'oxygène dans la couche centrale C2. En effet, la tension électrique de formation appliquée doit dépasser une valeur prédéterminée de manière à arracher des ions oxygène du réseau cristallin de la couche centrale en oxyde métallique qui vont migrer vers l'électrode supérieure EL2 former ainsi un filament conducteur F à travers la couche centrale constitué des lacunes d'oxygène.

Une fois le filament conducteur F formé, on obtient le comportement d'élément résistif à une résistance variable R selon la longueur I du filament conducteur F. Lorsqu'une tension électrique positive est appliquée sur l'électrode inférieure EL1, c'est la réaction inverse qui se produit et des ions oxygènes vont venir combler une partie des lacunes d'oxygène formant le filament conducteur. Il en résulte une réduction de la longueur du filament conducteur. Ainsi, la résistance de l'élément résistif augmente. On parle d'un état résistif haut et d'une opération d'écriture de type RESET. Inversement, lorsqu'une tension électrique positive est appliquée sur l'électrode supérieure EL2, la longueur du filament conducteur F s'accroît par le même mécanisme décrit pour l'opération de formation du fil. Ainsi, la résistance de l'élément résistif diminue. On parle d'un état résistif bas et d'une opération d'écriture de type SET.

On choisit la convention suivante à titre d'exemple : lorsqu'un composant mémoire NVM est configuré pour stocker une donnée binaire à l'état logique haut (x= 1) on applique temporairement une tension électrique d'écriture sur l'électrode supérieure EL2 (opération SET) de manière à obtenir un état résistif bas. Inversement, lorsqu'un composant mémoire NVM est configuré pour stocker une donnée binaire à l'état logique bas (x= 0) on applique temporairement une tension électrique d'écriture sur l'électrode inférieure EL1 (opération RESET) de manière à obtenir un état résistif haut.

La lecture d'un composant mémoire NVM résistif consiste à estimer la résistance entre l'électrode supérieure et l'électrode inférieure et à la comparer à une valeur seuil pour déterminer si l'état résistif est un état haut ou bas.

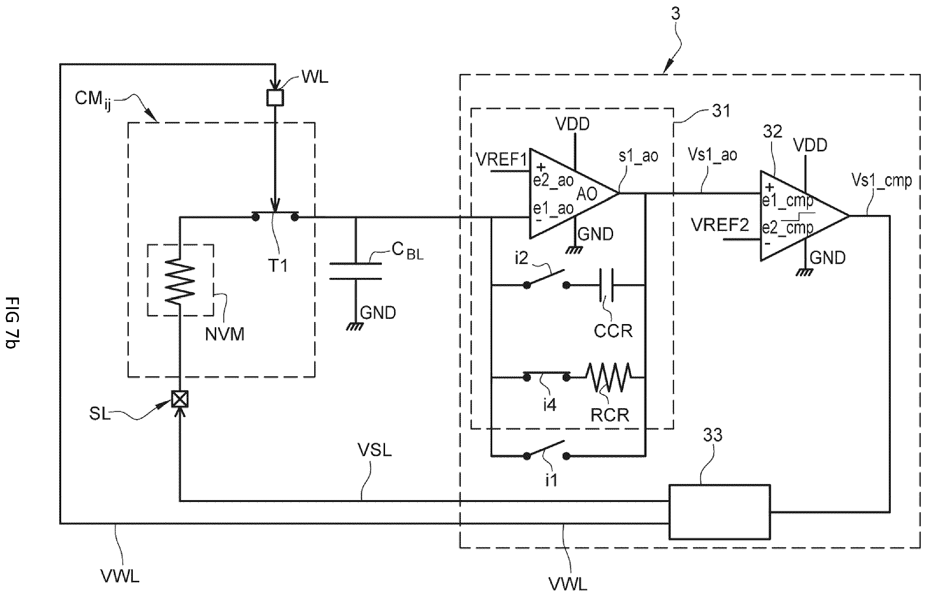

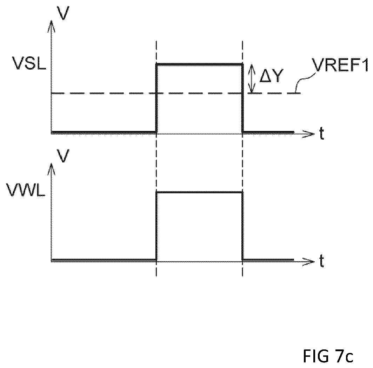

La figure 7b illustre un schéma électrique d'un second mode de réalisation du circuit de lecture 3 selon l'invention connecté à une cellule mémoire résistive à filament conducteur variable. La figure 7c illustre un organigramme des signaux de contrôle de la cellule mémoire résistive lors de la lecture d'une cellule mémoire par le circuit de lecture selon l'invention.

Dans ce mode de réalisation, le composant élémentaire NVM se comporte comme une résistance. Le circuit de lecture 3 comprend en outre une impédance résistive de rétroaction RCR montée entre la sortie s1_ao et la première entrée e1_ao de l'amplificateur opérationnel AO.

Avantageusement, le circuit de lecture 3 comprend un second interrupteur d'activation de rétroaction i4 entre l'impédance résistive de rétroaction RCR et la première entrée e1_ao de l'amplificateur opérationnel A0.

Pour lire le contenu logique de la cellule mémoire CMᵢⱼ résistive, le second interrupteur d'activation de rétroaction i4 est à l'état passant et le premier interrupteur d'activation de rétroaction i2 est à l'état bloquant. Le séquenceur 33 est configuré pour appliquer un signal de contrôle de lecture positif VSL sur le premier nœud d'entrée/sortie SL avec le transistor T1 à l'état passant. L'amplitude du signal de contrôle de lecture positif VSL est supérieure à celle du premier signal de référence VREF1 (potentiel du second nœud BL). Le composant élémentaire résistif NVM est alors soumis à une différence de potentiel non nulle. Il en résulte la circulation d'un courant électrique I1 à travers la résistance NVM et l'impédance résistive de rétroaction RCR. L'intensité du courant I1 dépend de l'état résistif du filament du composant élémentaire NVM. Cela induit une variation de la tension VRCR aux bornes de l'impédance résistive de rétroaction RCR qui dépend de l'intensité du courant I1. Il en résulte une variation du potentiel électrique au nœud de sortie s1_ao de l'amplificateur opérationnel AO. Cette variation de tension est une image de l'état résistif du composant élémentaire NVM selon le contenu logique stocké dans ledit composant. La lecture d'un composant élémentaire NVM n'est pas destructrice du contenu logique de la cellule mémoire. Il n'y a pas besoin d'une étape de réécriture dans ce cas.

## Revendications

1. Circuit de stockage de données (1) comprenant :
- une matrice (2) de cellules mémoire telle que chaque cellule mémoire (CMᵢⱼ) comprend :
• un composant élémentaire de stockage (NVM) de type ferroélectrique à polarisation électrique variable et ayant une première électrode (EL1) et une seconde électrode (EL2) ;
• un premier nœud d'entrée/sortie (SL) connecté à la seconde électrode (EL2) ; un second nœud d'entrée/sortie (BL) ; un nœud de sélection (WL);
• un transistor de sélection (T1) ayant une grille connectée au nœud de sélection (WL) et reliant la première électrode (EL1) au second nœud d'entrée/sortie (BL) ; dans laquelle, chaque cellule mémoire peut présenter un premier (« 0 ») ou un deuxième (« 1 ») état logique correspondant respectivement à des niveaux différents de charges stockées dans le composant élémentaire de stockage (NVM) associé ;
- un circuit de lecture (3) associé à au moins une cellule mémoire, comprenant
• un étage amplificateur à transimpédance capacitive (31) configuré pour lire une donnée stockée dans une cellule mémoire (CMᵢⱼ) sélectionnée via la mise en conduction du transistor de sélection (T1) correspondant en appliquant un signal de sélection (VWL) sur le nœud de sélection (WL) ; ledit étage amplificateur à transimpédance capacitive (31) comprenant :
∘ un amplificateur opérationnel (AO) ayant : une première entrée (e1_ao) connectée au second nœud d'entrée/sortie (BL) de la cellule mémoire associée, une seconde entrée (e2_ao) pour recevoir un premier signal de référence (VREF1) ; et une sortie (s1_ao) pour fournir un signal de lecture (Vs1_ao) analogique ;
∘ une impédance capacitive de rétroaction (CCR) montée entre la sortie (s1_ao) et la première entrée (e1_ao) de l'amplificateur opérationnel.
- un circuit séquenceur (33) configuré pour, suite à la lecture d'une donnée correspondant au second état logique (« 1 »), appliquer un signal de contrôle (VSL) sur le premier nœud d'entrée/sortie (SL) ayant une amplitude inférieure au premier signal de référence (VREF1) et maintenir le transistor de sélection (T1) à un état passant de sorte à remettre, dans le composant élémentaire de stockage (NVM) de la cellule mémoire sélectionnée, un niveau de charges correspondant au second état logique (« 1 »).

2. Circuit de stockage de données (1) selon la revendication 1, dans lequel ledit circuit séquenceur (33) est configuré pour, lors de la lecture, appliquer un signal de contrôle (VSL) sur le premier nœud d'entrée/sortie (SL) ayant une amplitude sensiblement égale au premier signal de référence (VREF1) de sorte à engendrer un transfert de charges depuis le composant élémentaire de stockage (NVM) de la cellule sélectionnée vers ledit étage amplificateur à transimpédance capacitive (31).

3. Circuit de stockage de données (1) selon la revendication 2, dans lequel ledit premier état logique («0») correspond à un état non chargé d'un composant élémentaire de stockage (NVM), et dans lequel ledit circuit séquenceur (33) est tel que, suite à la lecture d'une donnée correspondant à un premier état logique (« 0 »), ledit circuit séquenceur (33) est configuré pour rendre non conducteur ledit transistor de sélection (T1) dela cellule mémoire sélectionnée (CMᵢⱼ) avant de modifier le signal de contrôle (VSL) sur le premier nœud d'entrée/sortie (SL) vers une nouvelle valeur, pour maintenir la cellule mémoire venant d'être lue à un état non chargé.

4. Circuit de stockage de données (1) selon l'une quelconque des revendications 1 à 3 dans lequel le circuit de lecture (3) comprend en outre un comparateur (32) ayant
une première entrée (e1_cmp) connectée à la sortie (s1_ao) de l'amplificateur opérationnel,
une seconde entrée (e2_cmp) pour recevoir un second signal de référence (VREF2) ;
et une sortie (s1_cmp) pour fournir un signal de lecture (Vs1_cmp) numérique ;

5. Circuit de stockage de données (1) selon l'une quelconque des revendications 1 à 4 dans lequel :
• le signal de contrôle (VSL) est une première impulsion ;
• le signal de sélection (VWL) est une seconde impulsion;
le circuit séquenceur (33) étant configuré pour réduire la durée de la première impulsion par rapport à celle de la seconde impulsion suite à la lecture d'une donnée correspondant à un état logique haut.

6. Circuit de stockage de données (1) selon l'une quelconque des revendications 1 à 5 dans lequel le circuit de lecture (3) comprend en outre un interrupteur de réinitialisation (i1) monté entre la sortie (s1_ao) et la première entrée (e1_ao) de l'amplificateur opérationnel.

7. Circuit de stockage de données (1) selon l'une quelconque des revendications 1 à 6 dans lequel le circuit de lecture (3) comprend en outre un premier interrupteur d'activation de rétroaction (i2) entre l'impédance capacitive de rétroaction (CCR) et la première entrée (e1_ao) de l'amplificateur opérationnel.

8. Circuit de stockage de données (1) selon l'une quelconque des revendications 1 à 7 comprenant un interrupteur d'activation de lecture (i3) entre la première entrée (e1_ao) de l'amplificateur opérationnel et le second nœud d'entrée/sortie (BL) de la cellule mémoire associée.

9. Circuit de stockage de données (1) selon l'une quelconque des revendications 3 à 8 dans lequel le circuit de lecture (3) est configuré pour réaliser en outre, avant la lecture de ladite cellule mémoire associée:
une étape de réinitialisation pour décharger l'impédance capacitive de rétroaction (CCR) et polariser la première entrée (e1_ao) de l'amplificateur opérationnel au premier signal de référence (VREF1) ;

10. Circuit de stockage de données (1) selon l'une quelconque des revendications 1 à 9 dans lequel l'amplitude du premier signal de référence (VREF1) est comprise dans l'intervalle [VDD/2 - 50% ; VDD/2 + 50%] avec VDD une tension d'alimentation du circuit de stockage de données (1).

11. Circuit de stockage de données (1) selon l'une quelconque des revendications 1 à 10 comprenant au moins un composant élémentaire de stockage (NVM) configurable selon une configuration de fonctionnement correspondant à une mémoire résistive à filament conducteur variable ;
Le circuit de lecture (3) comprenant en outre :
• une impédance résistive de rétroaction (RCR) montée entre la sortie (s1_ao) et la première entrée (e1_ao) de l'amplificateur opérationnel (AO) ;
• un second interrupteur d'activation de rétroaction (i4) entre l'impédance résistive de rétroaction (RCR) et la première entrée (e1_ao) de l'amplificateur opérationnel (A0) .

12. Circuit de stockage de données (1) selon l'une quelconque des revendications 1 à 11 dans lequel la matrice (2) de cellules mémoire est composée de N lignes et M colonnes tel que :
- les cellules mémoire (CMᵢⱼ) appartenant à une même colonne présentent des premiers nœuds d'entrée/sortie (SL) interconnectés, et des seconds nœuds d'entrée/sortie (BL) interconnectés ;
- les cellules mémoire (CMᵢⱼ) appartenant à une même ligne présentent des nœuds de sélection (WL) interconnectés.

13. Circuit de stockage de données (1) selon l'une quelconque des revendications précédentes dans lequel le composant élémentaire de stockage (NVM) est de type FeRAM ou de type jonction tunnel ferroélectrique FTJ.

## Patentansprüche

1. Datenspeicherschaltung (1), die Folgendes umfasst:
- eine Matrix (2) aus Speicherzellen, so dass jede Speicherzelle (CMᵢⱼ) Folgendes umfasst:
• eine elementare Speicherkomponente (NVM) vom ferroelektrischen Typ mit variabler elektrischer Vorspannung und eine erste Elektrode (EL1) und eine zweite Elektrode (EL2) aufweisend;
• einen mit der zweiten Elektrode (EL2) verbundenen ersten Eingangs-/Ausgangsknoten (SL); einen zweiten Eingangs-/Ausgangsknoten (BL); einen Auswahlknoten (WL);
• einen Auswahltransistor (T1), der ein mit dem Auswahlknoten (WL) verbundenes Gate aufweist und der die erste Elektrode (EL1) mit dem zweiten Eingangs-/Ausgangsknoten (BL) verknüpft; wobei jede Speicherzelle einen ersten ("0") oder einen zweiten ("1") Logikzustand aufweisen kann, die jeweils unterschiedlichen Pegeln von Ladungen, die in der zugeordneten elementaren Speicherkomponente (NVM) gespeichert sind, entsprechen;
- eine Leseschaltung (3), die mindestens einer Speicherzelle zugeordnet ist, Folgendes umfassend:
• eine kapazitive Transimpedanzverstärkerstufe (31), die zum Lesen eines Datums konfiguriert ist, das in einer Speicherzelle (CMᵢⱼ) gespeichert ist, die durch Einschalten des entsprechenden Auswahltransistors (T1) durch Anlegen eines Auswahlsignals (VWL) an den Auswahlknoten (WL) ausgewählt ist; wobei die kapazitive Transimpedanzverstärkerstufe (31) Folgendes umfasst:
o einen betriebsfähigen Verstärker (AO) mit: einem ersten Eingang (e1_ao), der mit dem zweiten Eingangs-/Ausgangsknoten (BL) der zugeordneten Speicherzelle verbunden ist, einem zweiten Eingang (e2_ao) zum Empfangen eines ersten Referenzsignals (VREF1); und einem Ausgang (s1_ao) zum Bereitstellen eines analogen Lesesignals (Vs1_ao);
o eine kapazitive Rückkopplungsimpedanz (CCR), die zwischen dem Ausgang (s1_ao) und dem ersten Eingang (e1_ao) des betriebsfähigen Verstärkers montiert ist;
- eine Ablaufsteuerungsschaltung (33), konfiguriert zum Anlegen, nach dem Lesen eines dem zweiten Logikzustand ("1") entsprechenden Datums, eines Steuersignals (VSL) an den ersten Eingangs-/Ausgangsknoten (SL) mit einer Amplitude unterhalb des ersten Referenzsignals (VREF1) und zum Halten des Auswahltransistors (T1) in einem Durchlasszustand, um in der elementaren Speicherkomponente (NVM) der ausgewählten Speicherzelle einen Pegel von Ladungen entsprechend dem zweiten Logikzustand ("1") wiederherzustellen.

2. Datenspeicherschaltung (1) nach Anspruch 1, wobei die Ablaufsteuerungsschaltung (33) zum Anlegen, während des Lesens, eines Steuersignals (VSL) an den ersten Eingangs-/Ausgangsknoten (SL) mit einer Amplitude, die im Wesentlichen gleich dem ersten Referenzsignal (VREF1) ist, konfiguriert ist, um eine Übertragung von Ladungen von der elementaren Speicherkomponente (NVM) der ausgewählten Zelle zu der kapazitiven Transimpedanzverstärkerstufe (31) zu bewirken.

3. Datenspeicherschaltung (1) nach Anspruch 2, wobei der erste Logikzustand ("0") einem ungeladenen Zustand einer elementaren Speicherkomponente (NVM) entspricht, und wobei die Ablaufsteuerungsschaltung (33) derart ist, dass die Ablaufsteuerungsschaltung (33) nach dem Lesen eines einem ersten Logikzustand ("0") entsprechenden Datums zum Ausschalten des Auswahltransistors (T1) der ausgewählten Speicherzelle (CMᵢⱼ) konfiguriert ist, bevor sie das Steuersignal (VSL) am ersten Eingangs-/Ausgangsknoten (SL) auf einen neuen Wert ändert, um die gerade gelesene Speicherzelle in einem ungeladenen Zustand zu halten.

4. Datenspeicherschaltung (1) nach einem der Ansprüche 1 bis 3, wobei die Leseschaltung (3) ferner einen Komparator (32) umfasst mit
einem ersten Eingang (e1_cmp), der mit dem Ausgang (s1_ao) des betriebsfähigen Verstärkers verbunden ist,
einem zweiten Eingang (e2_cmp) zum Empfangen eines zweiten Referenzsignals (VREF2);
und einem Ausgang (s1_cmp) zum Bereitstellen eines digitalen Lesesignals (Vs1_cmp).

5. Datenspeicherschaltung (1) nach einem der Ansprüche 1 bis 4, wobei:
• das Steuersignal (VSL) ein erster Impuls ist;
• das Auswahlsignal (VWL) ein zweiter Impuls ist;
wobei die Ablaufsteuerungsschaltung (33) zum Reduzieren der Dauer des ersten Impulses im Verhältnis zu der des zweiten Impulses nach dem Lesen eines Datums entsprechend einem hohen Logikzustand konfiguriert ist.

6. Datenspeicherschaltung (1) nach einem der Ansprüche 1 bis 5, wobei die Leseschaltung (3) ferner einen Rücksetzschalter (i1) umfasst, der zwischen dem Ausgang (s1_ao) und dem ersten Eingang (e1_ao) des betriebsfähigen Verstärkers montiert ist.

7. Datenspeicherschaltung (1) nach einem der Ansprüche 1 bis 6, wobei die Leseschaltung (3) ferner einen ersten Rückkopplungsaktivierungsschalter (i2) zwischen der kapazitiven Rückkopplungsimpedanz (CCR) und dem ersten Eingang (e1_ao) des betriebsfähigen Verstärkers umfasst.

8. Datenspeicherschaltung (1) nach einem der Ansprüche 1 bis 7, die einen Leseaktivierungsschalter (i3) zwischen dem ersten Eingang (e1_ao) des betriebsfähigen Verstärkers und dem zweiten Eingangs-/Ausgangsknoten (BL) der zugeordneten Speicherzelle umfasst.

9. Datenspeicherschaltung (1) nach einem der Ansprüche 3 bis 8, wobei die Leseschaltung (3) so konfiguriert ist, dass sie vor dem Lesen der zugeordneten Speicherzelle ferner Folgendes durchführt:
einen Rücksetzschritt zum Entladen der kapazitiven Rückkopplungsimpedanz (CCR) und zum Vorspannen des ersten Eingangs (e1_ao) des betriebsfähigen Verstärkers auf das erste Referenzsignal (VREF1).

10. Datenspeicherschaltung (1) nach einem der Ansprüche 1 bis 9, wobei die Amplitude des ersten Referenzsignals (VREF1) im Intervall [VDD/2 - 50 %; VDD/2 + 50 %] liegt, wobei VDD eine Versorgungsspannung der Datenspeicherschaltung (1) ist.

11. Datenspeicherschaltung (1) nach einem der Ansprüche 1 bis 10, die mindestens eine elementare Speicherkomponente (NVM) umfasst, die gemäß einer Betriebskonfiguration, die einem resistiven Speicher mit variablem leitfähigem Filament entspricht, konfigurierbar ist;
wobei die Leseschaltung (3) ferner Folgendes umfasst:
• eine resistive Rückkopplungsimpedanz (RCR), die zwischen dem Ausgang (s1_ao) und dem ersten Eingang (e1_ao) des betriebsfähigen Verstärkers (AO) montiert ist;
• einen zweiten Rückkopplungsaktivierungsschalter (i4) zwischen der resistiven Rückkopplungsimpedanz (RCR) und dem ersten Eingang (e1_ao) des betriebsfähigen Verstärkers (AO).

12. Datenspeicherschaltung (1) nach einem der Ansprüche 1 bis 11, wobei die Speicherzellenmatrix (2) aus N Zeilen und M Spalten besteht, so dass:
- die zu einer selben Spalte gehörenden Speicherzellen (CMᵢⱼ) miteinander verbundene erste Eingangs-/Ausgangsknoten (SL), und miteinander verbundene zweite Eingangs-/Ausgangsknoten (BL) aufweisen;
- die zu einer selben Zeile gehörenden Speicherzellen (CMᵢⱼ) miteinander verbundene Auswahlknoten (WL) aufweisen.

13. Datenspeicherschaltung (1) nach einem der vorhergehenden Ansprüche, wobei die elementare Speicherkomponente (NVM) vom FeRAM-Typ oder vom ferroelektrischen Tunnelübergang FTJ-Typ ist.

## Claims

1. A data storage circuit (1) comprising:
- a matrix (2) of memory cells such that each memory cell (CMᵢⱼ) comprises:
• an elementary storage component (NVM) of ferroelectric type with variable electric bias and having a first electrode (EL1) and a second electrode (EL2);
• a first input/output node (SL) connected to the second electrode (EL2); a second input/output node (BL); a selection node (WL);
• a selection transistor (T1) having a gate connected to the selection node (WL) and linking the first electrode (EL1) to the second input/output node (BL); wherein each memory cell can have a first ("0") or a second ("1") logic state corresponding respectively to different levels of charges stored in the associated elementary storage component (NVM);
- a read circuit (3) associated with at least one memory cell, comprising:
• a capacitive transimpedance amplifier stage (31) configured to read a piece of data stored in a memory cell (CMᵢⱼ) selected via the switching-on of the corresponding selection transistor (T1) by applying a selection signal (VWL) to the selection node (WL); said capacitive transimpedance amplifier stage (31) comprising:
∘ an operational amplifier (AO) having: a first input (e1_ao) connected to the second input/output node (BL) of the associated memory cell, a second input (e2_ao) for receiving a first reference signal (VREF1); and an output (s1_ao) for providing an analogue read signal (Vs1_ao);
∘ a feedback capacitive impedance (CCR) mounted between the output (s1_ao) and the first input (e1_ao) of the operational amplifier;
- a sequencer circuit (33) configured to, following the reading of a piece of data corresponding to the second logic state ("1"), apply a control signal (VSL) to the first input/output node (SL) having an amplitude lower than the first reference signal (VREF1) and maintain the selection transistor (T1) in an on state so as to restore, in the elementary storage component (NVM) of the selected memory cell, a level of charges corresponding to a second logic state ("1").

2. The data storage circuit (1) according to claim 1, wherein said sequencer circuit (33) is configured to, during the reading, apply a control signal (VSL) to the first input/output node (SL) having an amplitude substantially equal to the first reference signal (VREF1) so as to create a transfer of charges from the elementary storage component (NVM) of the selected cell to said capacitive transimpedance amplifier stage (31).

3. The data storage circuit (1) according to claim 2, wherein said first logic state ("0") corresponds to a non-charged state of an elementary storage component (NVM), and wherein said sequencer circuit (33) is such that, following the reading of a piece of data corresponding to a first logic state ("0"), said sequencer circuit (33) is configured to switch off said selection transistor (T1) of the selected memory cell (CMᵢⱼ) before modifying the control signal (VSL) on the first input/output node (SL) to a new value, to maintain the memory cell that has just been read in a non-charged state.

4. The data storage circuit (1) according to any one of claims 1 to 3, wherein the read circuit (3) further comprises a comparator (32) having
a first input (e1_cmp) connected to the output (s1_ao) of the operational amplifier,
a second input (e2_cmp) for receiving a second reference signal (VREF2);
and an output (s1_cmp) for providing a digital read signal (Vs1_cmp).

5. The data storage circuit (1) according to any one of claims 1 to 4, wherein:
• the control signal (VSL) is a first pulse;
• the selection signal (VWL) is a second pulse;
the sequencer circuit (33) being configured to reduce the duration of the first pulse with respect to that of the second pulse following the reading of a piece of data corresponding to a high logic state.

6. The data storage circuit (1) according to any one of claims 1 to 5, wherein the read circuit (3) further comprises a reset switch (i1) mounted between the output (s1_ao) and the first input (e1_ao) of the operational amplifier.

7. The data storage circuit (1) according to any one of claims 1 to 6, wherein the read circuit (3) further comprises a first feedback activation switch (i2) between the feedback capacitive impedance (CCR) and the first input (e1_ao) of the operational amplifier.

8. The data storage circuit (1) according to any one of claims 1 to 7, comprising a read activation switch (i3) between the first input (e1_ao) of the operational amplifier and the second input/output node (BL) of the associated memory cell.

9. The data storage circuit (1) according to any one of claims 3 to 8, wherein the read circuit (3) is configured to further perform, before the reading of said associated memory cell:
a reset step for discharging the feedback capacitive impedance (CCR) and biasing the first input (e1_ao) of the operational amplifier to the first reference signal (VREF1).

10. The data storage circuit (1) according to any one of claims 1 to 9, wherein the amplitude of the first reference signal (VREF1) lies within the interval [VDD/2 - 50%; VDD/2 + 50%] with VDD a power supply voltage of the data storage circuit (1).

11. The data storage circuit (1) according to any one of claims 1 to 10, comprising at least one elementary storage component (NVM) that can be configured according to an operating configuration corresponding to a resistive memory with variable conductive filament;
the read circuit (3) further comprising:
• a feedback resistive impedance (RCR) mounted between the output (s1_ao) and the first input (e1_ao) of the operational amplifier (AO);
• a second feedback activation switch (i4) between the feedback resistive impedance (RCR) and the first input (e1_ao) of the operational amplifier (AO).

12. The data storage circuit (1) according to any one of claims 1 to 11, wherein the matrix (2) of memory cells is composed of N rows and M columns such that:
- the memory cells (CMᵢⱼ) belonging to one and the same column have interconnected first input/output nodes (SL), and second interconnected input/output nodes (BL);
- the memory cells (CMᵢⱼ) belonging to one and the same row have interconnected selection nodes (WL).

13. The data storage circuit (1) according to any one of the preceding claims, wherein the elementary storage component (NVM) is of FeRAM type or of ferroelectric tunnel junction FTJ type.
